# EUROPEAN PATENT SPECIFICATION

(11) **EP 4 191 689 B1**
(45) Date of publication and mention of the grant of the patent: **21.08.2024**
(21) Application number: 22209237.1
(22) Date of filing: 23.11.2022
(51) Int. Cl.: H01L 33/48, H01L 33/62

(54) **SEMICONDUCTOR LIGHT EMITTING DEVICE**
LICHTEMITTIERENDES HALBLEITERBAUELEMENT
DISPOSITIF ÉLECTROLUMINESCENT À SEMI-CONDUCTEUR

(30) Priority: 02.12.2021 JP 2021196554
(43) Date of publication of application: 07.06.2023
(73) Proprietor: STANLEY ELECTRIC CO., LTD., Tokyo 153-8636 (JP)
(72) Inventor: SHIMODA, Yoichi, Tokyo, 153-8636 (JP); KAMBARA, Daizo, Tokyo, 153-8636 (JP); SHIGEEDA, Yuji, Tokyo, 153-8636 (JP); ICHIKAWA, Koji, Tokyo, 153-8636 (JP); ISHIKO, Hiroyuki, Tokyo, 153-8636 (JP)
(74) Representative: Schmidbauer, Andreas Konrad

(56) References cited:
- EP-A1- 2 541 598
- EP-A1- 3 226 312
- JP-A- 2018 061 026
- KR-A- 20090 104 512
- US-A1- 2012 025 227
- US-A1- 2012 056 218
- US-A1- 2012 074 456
- US-A1- 2012 280 375
- US-A1- 2013 127 034
- US-A1- 2013 187 188
- US-A1- 2018 097 163
- US-A1- 2019 165 233

## Description

### BACKGROUND OF THE INVENTION

### 1. Field of the Invention

The present invention relates to a light emitting device and more particularly to a semiconductor light emitting device having a semiconductor light emitting element such as a light emitting diode (LED).

### 2. Description of the Related Art

Hitherto, there has been known a light emitting device formed by providing a resin body in a lead frame by insert molding and cutting the lead frame with the resin body therein by a dicer.

For example, JP 2010-62272 A discloses a method for forming a light emitting device by forming a frame-shaped resin molding in a lead frame provided with cutouts, and then cutting the assembly of the resin molding and the lead frame along the cutouts.

In the light emitting device of JP 2010-62272 A, the resin of the resin molding is filled in the cutouts of the lead frame, so that the adhesion between the resin molding and the lead frame is enhanced. However, the height of the surface of contact between the resin and the cutouts is equivalent to the thickness of the lead frame at most, and an increase of the contact area is restricted.

Further, JP 2006-156704 A discloses a surface mounting type light emitting device that has a frame-shaped first resin molding integrally molded with a first lead for placing a light emitting element thereon and a second lead electrically connected to the first lead, and a second resin molding that covers the light emitting element and is joined to the first lead and the second lead on the lower side. Both the first resin molding and the second resin molding of the surface mounting type light emitting device are made of a thermosetting resin.

In the surface mounting type light emitting device of JP 2006-156704 A, the adhesion between the second resin molding and the lead frame is improved, thus leading to a possibility of an increase in the adhesion between the first resin molding, which is made of a thermosetting resin and is in close contact with the second resin molding made also of a thermosetting resin, and the lead frame through the intermediary of the second resin molding.

US 2018/097163 A1 discloses a light emitting device which includes a resin molded body, which includes a front surface having an opening, a bottom surface opposite to the opening a front-rear direction of the light emitting device, and first and second wall portions extending from the bottom surface to the front surface. A first lead includes a first bottom portion provided on the bottom surface, first and second side portions provided in the first and second wall portions, respectively. A second lead include a second bottom portion provided on the bottom surface apart from the first lead to provide a first resin region, third and fourth side portions provided in the first and second wall portions apart from the first lead to provide second and third resin regions, respectively. The first resin region is provided between the second resin region and the third resin region viewed in the front-rear direction.

US 2012/280375 A1 discloses a semiconductor package comprising a lead part coupled to a semiconductor element by wire bonding, an element retention member to retain the semiconductor element on the top face side and radiate heat on the bottom face side, and an insulative partition part to partition the lead part from the element retention member with an insulative resin, wherein a creeping route ranging from the top face retaining the semiconductor element to a package bottom face on a boundary plane between the element retention member and an insulative partition part includes a bent route having a plurality of turns. Consequently, it is possible to inhibit an encapsulation resin to seal a region retaining the semiconductor element from exuding toward the bottom face side of the package.

KR 2009 0104512 A discloses a light emitting diode package including a housing, a lead frame, and airtight intensifiers. In the housing, a cavity for accommodating an LED chip is formed. The lead frame is extended to the outside of the housing and passes the housing from the cavity. The lead frame has a bending part interposed between the inner wall and exterior wall. The airtight intensifier surrounds the bending of the lead frame to strengthen the airtightness of the part in which the lead frame is interposed in the housing.

However, in the prior arts, there is sufficient room for improvement in the adhesion between a resin molding and a lead frame.

### SUMMARY OF THE INVENTION

The present invention has been made in view of the aspects described above, and an object of the present invention is to provide a semiconductor light emitting device having a structure that exhibits high adhesion between a frame made of a resin and a lead frame made of a metal, thus preventing separation between the resin of the frame and the lead frame and minimizing the occurrence of disconnection failure and the like.

A semiconductor light emitting device according to the present invention is provided as set forth in claim 1.

Preferred embodiments of the present invention may be gathered from the dependent claims.

### BRIEF DESCRIPTION OF THE DRAWINGS

FIG. 1 is a perspective view schematically illustrating a semiconductor light emitting device of a first embodiment of the present invention;
FIG. 2 is a top view of a lead frame of the first example;
FIG. 3 is a top view schematically illustrating the inside of the semiconductor light emitting device;
FIG. 4A is a diagram illustrating the upper surface of the semiconductor light emitting device;
FIG. 4B is a side view of the semiconductor light emitting device observed from the direction indicated by arrow IVB in FIG. 4A;
FIG. 5 is a sectional view along line V-V in FIG. 4A;
FIG. 6 is an enlarged sectional view illustrating the right half of FIG. 5;
FIG. 7 is a diagram schematically illustrating the sections (upper and lower) of a lead before and after a standing part is formed;
FIG. 8 is a sectional view across the lead in the semiconductor light emitting device;
FIG. 9 is a detailed connection diagram of an LED with a bonding wire;
FIG. 10A is a diagram illustrating the configuration of a standing part in a lead frame of modified example 1;
FIG. 10B is a diagram schematically illustrating the section of a lead before and after the standing part in the lead frame of modified example 1 is formed;
FIG. 11A is a configuration diagram of a standing part in a lead frame of modified example 2;
FIG. 11B is a diagram schematically illustrating the section of a lead before and after the standing part in the lead frame of modified example 2 is formed;
FIG. 12A is a diagram illustrating STEP1 of the manufacturing method of the semiconductor light emitting device;
FIG. 12B is a diagram illustrating STEP2 of the manufacturing method of the semiconductor light emitting device;
FIG. 12C is a diagram illustrating STEPS of the manufacturing method of the semiconductor light emitting device;
FIG. 12D is a diagram illustrating STEP4 of the manufacturing method of the semiconductor light emitting device;
FIG. 12E is a diagram illustrating STEPS of the manufacturing method of the semiconductor light emitting device;
FIG. 12F is a diagram illustrating STEP6 of the manufacturing method of the semiconductor light emitting device;
FIG. 13A is a top view of a lead frame of a second embodiment of the present invention;
FIG. 13B is a sectional view along line XIIIB-XIIIB of FIG. 13A;
FIG. 13C is an enlarged view of a standing part of a lead frame of modified example 3;
FIG. 14A is a top view of a lead frame of an example not forming part of the present invention;
FIG. 14B is a side view of a light emitting device provided with the lead frame of FIG. 14A observed in a longitudinal direction from the lead side; and
FIG. 14C is a sectional view of the semiconductor light emitting device provided with the lead frame of FIG. 14A cut by a plane parallel to a slit and across an LED.

### DESCRIPTION OF THE PREFERRED EMBODIMENTS

The following will describe preferred embodiments of the present invention on the basis of a plurality of examples and modified examples thereof, which may be altered and combined as appropriate. Further, in the following description and accompanying drawings, substantially the same or equivalent parts will be denoted by the same reference numerals.

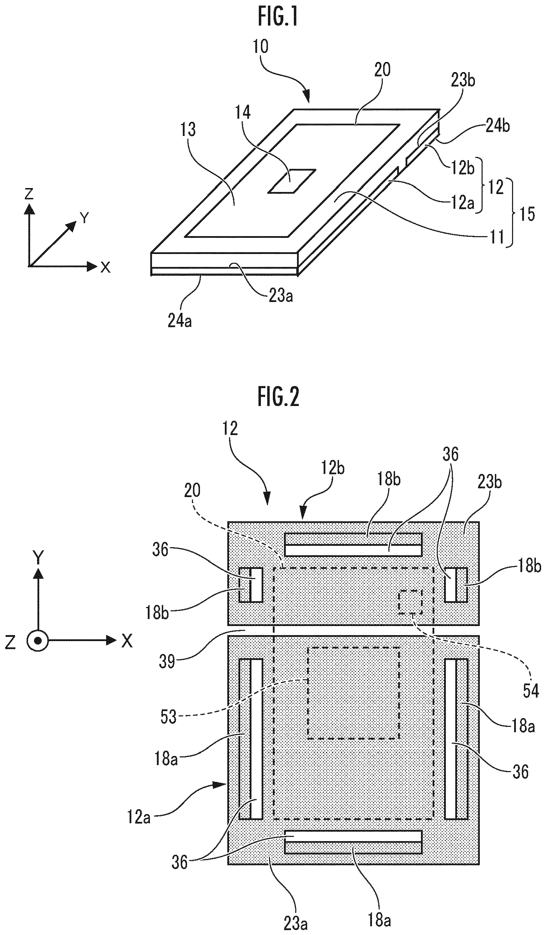

FIG. 1 is a perspective view schematically illustrating a semiconductor light emitting device 10 (hereinafter may be referred to also as "the light emitting device") of a first embodiment of the present invention. A three-axis coordinate system is added for the convenience of indicating corresponding directions among a plurality of drawings. A Z-axis direction corresponds to the vertical direction of the light emitting device 10, and an X-axis direction and a Y-axis direction correspond to the lateral direction and the longitudinal direction, respectively, of a lead frame 12.

In FIG. 1, the light emitting device 10 has a substrate 15 which has a rectangular shape and is composed of a frame 11 on the upper side and a lead frame 12 on the lower side, both of which have the same rectangular shape. A covering member 13 is provided on the inner side of the frame 11, and a phosphor plate 14 is exposed through the covering member 13.

The frame 11 is made of, for example, a thermosetting resin material, and has an opening 20. The substrate 15 is formed by integrally molding the frame 11 and the lead frame 12 by transfer molding.

FIG. 2 is a top view of the lead frame 12 of the first example. The lead frame 12 is separated into leads 12a and 12b in the longitudinal direction (the Y-axis direction) by a slit 39 extending in the lateral direction (the X-axis direction). The leads 12a and 12b have upper surfaces 23a and 23b, respectively. Further, the leads 12a and 12b have lower surfaces 24a and 24b (FIG. 1), respectively, on the opposite side from the upper surfaces 23a and 23b. The lower surfaces 24a and 24b of the leads 12a and 12b function as the mounting electrodes of the light emitting device 10.

Die pads 53 and 54 are set on the upper surfaces 23a and 23b of the leads 12a and 12b as mounting places for a light emitting element and a protection element. Referring to FIG. 2, the dashed line of the opening 20 indicates the peripheral line, along which the peripheral edge of the opening on the lower end side of the opening 20 is located. The opening 20 has a rectangular shape, and the die pads 53 and 54 are positioned on the inner side the opening 20 indicated by the dashed line and exposed to the opening 20.

Standing parts 18a and 18b, which continue from the leads 12a and 12b and extend above the upper surfaces 23a and 23b of the leads 12a and 12b (in the Z-axis direction), are provided one each along three sides excluding the one side adjacent to the slit 39 in the leads 12a and 12b. In addition, through holes 36, which are holes penetrating from the upper surfaces 23a and 23b of the leads 12a and 12b to the lower surfaces 24a and 24b, are formed in the leads 12a and 12b in such a manner as to extend along the standing parts 18a and 18b and be adjacent to the standing parts 18a and 18b. In the lead frame 12 of the first example illustrated in FIG. 2, all the through holes 36 are located on the peripheral edge side of the lead frame 12 with respect to the standing parts 18a and 18b.

Preferably, the standing parts 18a and 18b are provided at positions symmetrical with respect to the centerline in the longitudinal direction, and the lead frame 12 has a symmetrical structure. In addition, the standing parts 18a and 18b and the through holes 36 preferably have a structure parallel to the outer surface of the light emitting device 10. The standing parts 18a and 18b are embedded in the frame 11, the details of which will be described later. Further, the through holes 36 and the slit 39 are embedded with a resin forming the frame 11.

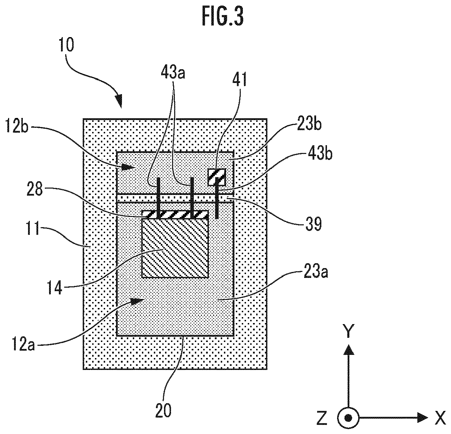

FIG. 3 is a top view schematically illustrating the inside of the light emitting device 10. FIG. 3 does not illustrate the covering member 13 (refer to FIG. 1), which covers the opening 20. The upper surface 23a of the lead 12a and the upper surface 23b of the lead 12b are exposed to the opening 20 of the frame 11. The thermosetting resin of the frame 11 includes the standing parts 18a and 18b and is filled in the slit 39 to enhance the adhesion between the frame 11 and the lead frame 12.

An LED 28 and a protection element 41 are placed at portions where the leads 12a and 12b are exposed to the opening 20. The protection element 41 is composed of, for example, a Zener diode, a varistor, or a capacitor, and prevents overcurrent from flowing to the LED 28.

The LED 28 and the protection element 41 are placed on the die pads 53 and 54 (FIG. 2), respectively, in the opening 20. The phosphor plate 14 is disposed on the upper surface of the LED 28. The LED 28 is connected to the upper surface 23b of the lead 12b through two bonding wires 43a. The protection element 41 is connected to the upper surface 23a of the lead 12a through a bonding wire 43b.

The leads 12a and 12b are a negative electrode (cathode) and a positive electrode (anode), respectively, of the light emitting device 10, and an applied voltage is supplied thereto from outside the light emitting device 10.

The frame 11 is formed of silicone resin and/or epoxy resin containing titanium oxide particles. As the resin used for the frame 11, a thermosetting resin such as, for example, an acrylic resin, a polycarbonate resin, or a phenolic resin can be used. Further, a resin additive may include, for example, a light absorbing material such as black titanium oxide particles or carbon black, and a thickening agent such as nanosilica.

The lead frame 12 is made of a plate-like metal having the upper surfaces 23a and 23b and the lower surfaces 24a and 24b of the leads 12a and 12b provided with plating films formed thereon. The core material of the plate-like metal is copper (Cu). The plating films have a two-layer structure (Ni/Au) of a lower nickel (Ni) layer and an upper gold (Au) layer. As a core material, a highly conductive metal such as, for example, aluminum (Al) or iron (Fe)-Ni-cobalt (Co) type alloy can be used. For the plating films, metal such as, for example, titanium (Ti)/Au or Ni/platinum (Pt), the upper side of which is a noble metal can be used. This improves solder adherence.

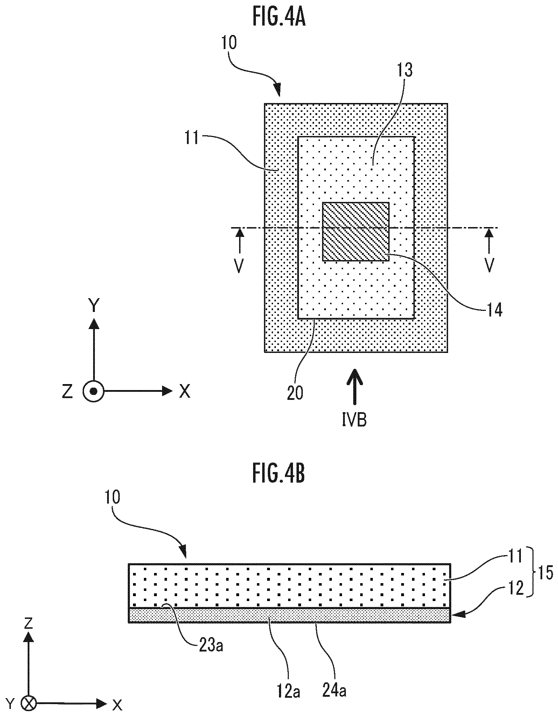

FIG. 4A is a diagram illustrating the upper surface of the light emitting device 10, and FIG. 4B is a side view of the light emitting device 10 observed from the direction indicated by arrow IVB in FIG. 4A.

Referring to FIG. 4A and FIG. 4B, in the light emitting device 10 of the first example, the substrate 15 composed of the lead frame 12 and the frame 11 has an outer periphery shaped like a rectangular parallelepiped. Further, the frame 11 extends over the entire periphery of the light emitting device 10 with a width that allows securing a predetermined area of close contact with the upper surface of the lead frame 12 on the lower side.

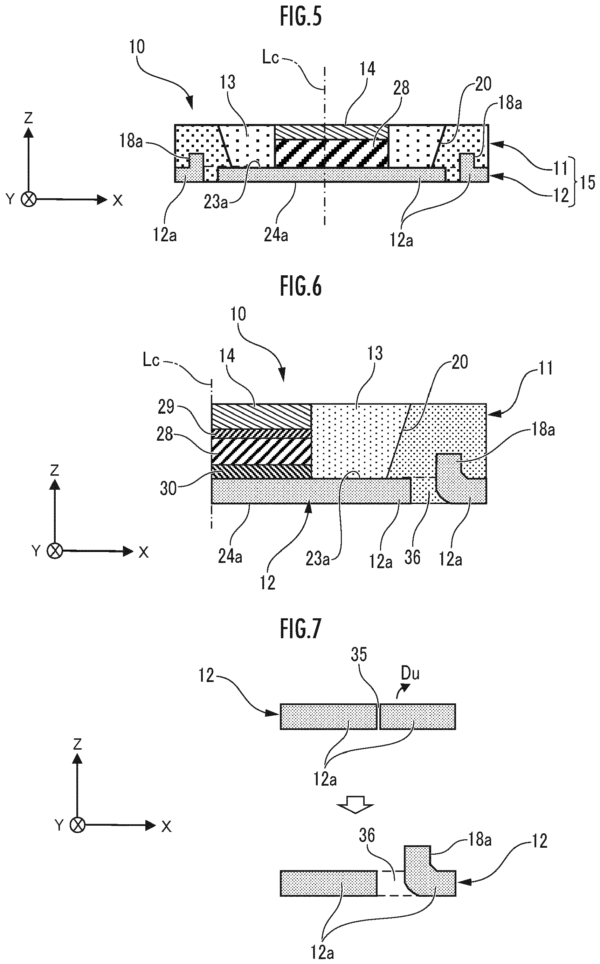

FIG. 5 is a sectional view along line V-V in FIG. 4A. The opening 20 of the frame 11 has a shape of an inverted truncated quadrangular pyramid with a rectangular bottom. Further, inside the frame 11, the LED 28 is mounted on the upper surface 23a of the lead 12a, and the phosphor plate 14, which is a wavelength converter, is provided on the upper surface of the LED 28.

Although the opening 20 has the shape of an inverted truncated quadrangular pyramid as illustrated in FIG. 5, the opening 20 may alternatively have a shape other than the shape of an inverted truncated quadrangular pyramid. The opening 20 may have a shape such as, for example, a truncated cone (including an elongated truncated cone), a prismatic shape, or a cylindrical shape.

FIG. 6 is an enlarged sectional view illustrating the right half of FIG. 5. A centerline Lc of the substrate 15 is shown as an auxiliary line. More specifically, referring to FIG. 6, the LED 28 is joined to the upper surface 23a of the lead 12a through a bonding layer 30. The bonding layer 30 is made of an Au-tin (Sn) type solder material. The phosphor plate 14 is bonded to the upper surface of the LED 28 through an adhesive layer 29, which transmits light emitted by the LED 28. In this example, the phosphor plate 14 uses silicone resin as the main component, but may alternatively use a low-temperature sintered material of nano-ceramic particles, or the like.

The covering member 13 is filled in the opening 20 and seals the opening 20 such that the upper surface of the phosphor plate 14 is exposed. The covering member 13 is made of, for example, a thermosetting silicone resin containing titanium oxide particles (white titanium oxide particles) having a diameter of 200 nm to 300 nm as a light reflecting material.

As can be seen from FIG. 6, a part of the thermosetting resin of the covering member 13 is filled in contact with the upper surface of the lead frame 12 and the frame 11 formed on the lead 12a. Further, the thermosetting resin is filled in contact with also the resin which is filled in the slit 39 and continues from the frame 11 (FIG. 3), so that the mechanical strength of the light emitting device 10 can be increased.

The LED 28 is a light emitting element that emits, for example, blue light. A part of the blue light emitted upward from the LED 28 is subjected to wavelength conversion into, for example, yellow light when passing through the phosphor plate 14. As a result, the emitted light from the light emitting device 10 becomes white, which is a mixture of blue light and yellow light that is transmitted without being wavelength-converted by the phosphor plate 14. Further, it is also possible to set such that all of the blue light emitted from the LED 28 is wavelength-converted by the phosphor plate 14. In this case, the emitted light from the light emitting device 10 becomes light of a color obtained by conversion by the phosphor plate 14, such as green, yellow, or red.

The light emitted sideways from the LED 28 and the phosphor plate 14 and incident upon the covering member 13 hits the light reflecting material contained in the covering member 13 and is reflected toward the LED 28 and the phosphor plate 14.

The light emitted from the LED 28 is not limited to blue light, and may alternatively be light in a visible light band such as red or green light, or light outside the visible light band such as ultraviolet light or infrared light. Further, rather than limiting to the wavelength converter (the phosphor plate 14), translucent glass or a diffractive optical element for controlling the light distribution of the light emitted from the LED 28 may be provided on the LED 28.

FIG. 7 is a diagram schematically illustrating the sections (upper and lower) of the leads 12a before and after the standing part 18a is formed.

Each of the standing parts 18a is formed by bending a part of the lead 12a made of a plate-like metal. The standing part 18a before formation is in the form of a rectangular region divided by two short cuts (not illustrated) which start from the linear bend side along the outer surface of the light emitting device 10 and which are orthogonal to the bend sides, and a long cut 35 parallel to the bend side.

The rectangular region turns into the standing part 18a by being rotated in a rotational direction Du by using the side (bend side) without the cut 35 as the rotation axis against the pressing force applied from the lower surface 24a side of the lead 12a to the upper surface 23a side. The hole formed in the lead 12a after the rectangular region has been rotated is a through hole 36.

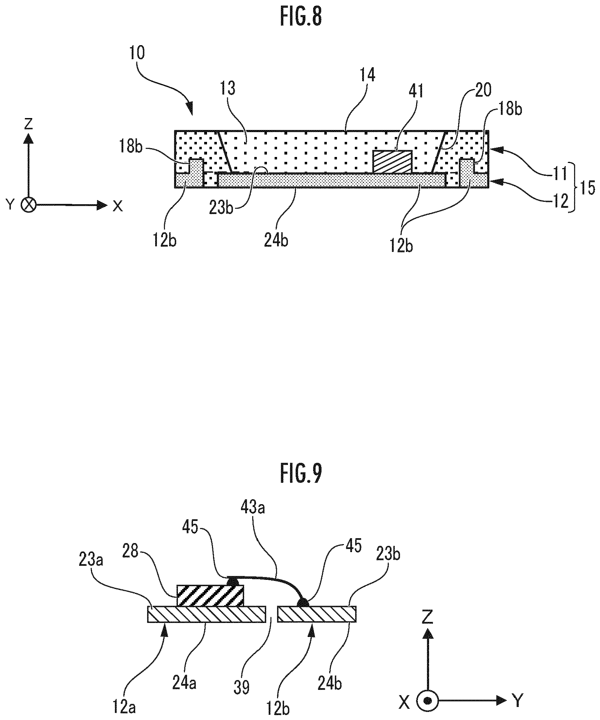

FIG. 8 is a sectional view across the lead 12b in the light emitting device 10. More specifically, the sectional view is obtained by cutting with a plane (XZ plane) which is parallel to the slit 39 and perpendicular to the lead 12b, and which crosses the standing parts 18b.

The upper surface 23b of the lead 12b is partly exposed to the opening 20. Further, the standing parts 18b are erected in the range of the upper surface 23b and embedded in the frame 11 without being exposed to the opening 20.

FIG. 9 is a detailed connection diagram of the LED 28 with the bonding wires 43a. FIG. 9 illustrates the electrical connection by the bonding wires 43a observed sideways. The bonding wires 43a are connected to the LED 28 from the lead 12b through bumps 45 provided on electrode pads (not illustrated) on the upper surface of the LED 28.

Although a detailed connection diagram of the protection element 41 with the bonding wire 43b is omitted, the bonding wire 43b interconnects the upper surface 23a of the lead 12a and the protection element 41 through the bumps provided on electrode pads (not illustrated) on the upper surface of the protection element 41, as illustrated in FIG. 3.

According to the lead frame 12 of the first example, the standing parts 18a and 18b erected on the upper surfaces 23a and 23b are embedded in the frame 11 made of resin. This increases the area of contact between the frame 11 made of resin and the lead frame 12 made of metal by the areas of both surfaces of the standing parts 18a and 18b, thus enhancing the adhesion between the frame 11 and the lead frame 12. In addition, the standing parts 18a and 18b are substantially orthogonal to the upper surfaces 23a and 23b of the lead frame 12, and have contact surfaces having the direction of adhesiveness to the frame 11 different by approximately 90°, so that the mechanical strength of the substrate 15 composed of the lead frame 12 and the frame 11 is improved. This makes it possible to suppress the detachment of the LED 28 and the protection element 41, the disconnection of the bonding wires 43a and 43b, and the like.

According to the lead frame 12 of the first example, the through hole 36 is formed in the interior covered by the frame 11 of the leads 12a and 12b. As a result, a sufficient contact area is secured between the peripheral wall of the through hole 36 and the resin, which is filled in the through hole 36 and forms the frame 11, thus making it possible to enhance the adhesion (adhesiveness) between the frame 11 and the lead frame 12.

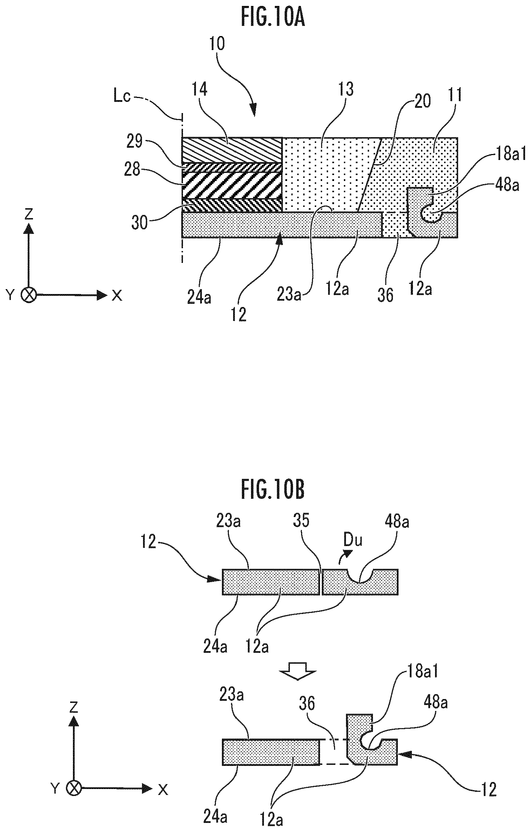

FIG. 10A is a diagram illustrating the configuration of a standing part 18a1 in a lead frame 12 of modified example 1. FIG. 10B is a diagram schematically illustrating the sections (upper and lower) of leads 12a before and after the standing part 18a1 in the lead frame 12 of modified example 1 is formed.

A description will be given by referring first to FIG. 10B. The standing part 18a1 before formation is in the form of a rectangular region on the upper surface 23a of the lead 12a, being divided by two short cuts (not illustrated) which start from both ends of a linear bend side (a bending guide groove 48a) along the outer surface of the light emitting device 10 and which are orthogonal to the bend side, and a long cut 35 parallel to the bend side before the standing part 18a1 is rotated in a rotational direction Du. Further, the bending guide groove 48a is formed in the bend side. The bending guide groove 48a can be formed by, for example, half-etching the lead frame 12. The bending guide groove 48a is provided also in the standing part of a lead 12b.

The rectangular region is rotated in the rotational direction Du by the pressing force applied from a lower surface 24a side of the lead 12a to an upper surface 23a side, with the bending guide groove 48a serving as the rotation axis, thereby forming the standing part 18a1.

According to the lead frame 12 of modified example 1, the standing part 18a1 is formed on the upper surface 23a of the lead 12a such that standing part 18a1 is erected with the bending guide groove 48a directed to the outer side of the frame 11, as illustrated in FIG. 10A.

The presence of the bending guide groove 48a makes it possible to accurately bend the standing part 18a1 along the line of the bending guide groove 48a. In addition, the portion of the plate thickness of the lead 12a where the bending guide groove 48a is provided is thinner, so that the pressing force for pressing the rectangular region that turns into the standing part 18a1 can be decreased. At the same time, the distortion of the portion of the lead 12a other than the standing part 18a1 can be prevented. Further, the proximal portion of the standing part 18a1 becomes thin and the distal end portion thereof becomes thick, thus making it possible to prevent the frame 11 from detaching from the lead 12a.

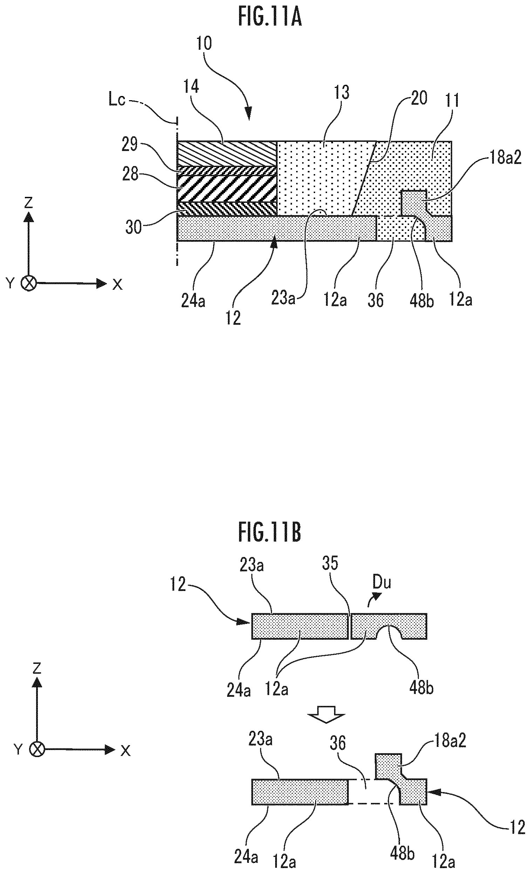

FIG. 11A is a configuration diagram of a standing part 18a2 in a lead frame 12 of modified example 2. FIG. 11B is a diagram schematically illustrating the sections (upper and lower) of a lead 12a before and after the standing part 18a2 in the lead frame 12 of modified example 2 is formed.

Modified example 2 is different from modified example 1 in that a bending guide groove 48b in the lead 12a, which serves as the bend side for the standing part 18a2, is formed in a lower surface 24a of the lead 12a.

According to the lead frame 12 of modified example 2, the standing part 18a2 is erected in such a manner as to face upward with respect to the lead frame 12, the bending guide groove 48b being the support point. As with the bending guide groove 48a, the bending guide groove 48b also functions to enable the standing part 18a2 to be accurately bent along the bending guide groove 48b.

In addition, the portion of the plate thickness of the lead 12a where the bending guide groove 48b is provided is thin, so that the pressing force for pressing the rectangular region that turns into the standing part 18a2 can be decreased. At the same time, the distortion of the portion of the lead 12a other than the standing part 18a2 can be prevented. Further, the proximal portion of the standing part 18a2 becomes thin and the distal end portion thereof becomes thick, thus making it possible to prevent the frame 11 from detaching from the lead 12a. Further, the bent portion of the standing part 18a2 becomes an upper surface 23a of the lead 12a, and the bent portion is not exposed to a lower surface 24a of the lead 12a. This makes it possible to prevent the resin of the frame 11 filled in a through hole 36 from covering the lower surface 24a of the lead 12a.

Although not illustrated, as still another modified example, both the bending guide grooves 48a and 48b rather than just one thereof may be formed in the lead 12a or the lead 12b.

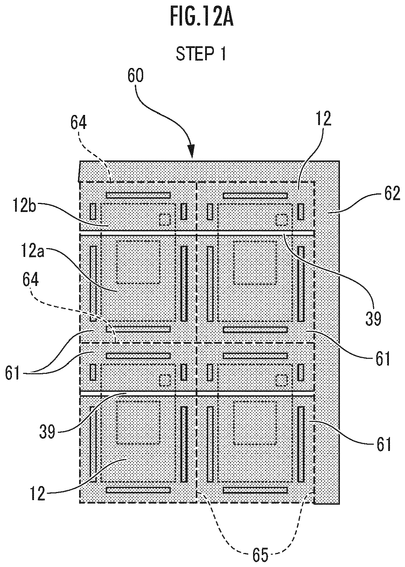

FIG. 12A to FIG. 12F illustrate the processes (STEPs) of the manufacturing method of the light emitting device 10 of the first embodiment in order.

The lead frame 12 is individually provided for each light emitting device 10, and is obtained by singulating a lead frame 60 illustrated in FIG. 12A to FIG. 12F. In the lead frame 60, a plurality of the lead frames 12 are arranged in a lattice as unitary sections 61. In FIG. 12A to FIG. 12F, the lead frame 60 is illustrated not as a whole but only the upper right corner of the whole.

In STEP (process) 1 in FIG. 12A, the lead frame 60 is prepared. The lead frame 60 includes the plurality of unitary sections 61 arranged in a lattice, and a margin 62 surrounding the periphery of the plurality of arranged unitary sections 61.

In FIG. 12A to FIG. 12F, lateral dicing lines 64 and longitudinal dicing lines 65, which divide the lead frame 60 into the unitary sections 61, are indicated by the dashed lines extending in the lateral direction and the longitudinal direction, respectively. The lateral dicing lines 64 and the longitudinal dicing lines 65 do not exist as structures in the actual lead frame 60, but are added in the drawings as virtual lines of boundaries of the unitary sections 61 for convenience of explanation.

The lead frame 60 illustrated in FIG. 12A can be processed into a predetermined shape by die-cut pressing, laser cutting, water jet processing, or etching. In the first example, die-cut pressing was used to form the lead frame 60. The bending guide grooves 48a and 48b of modified examples 1 and 2 were formed by half etching before the die-cut pressing.

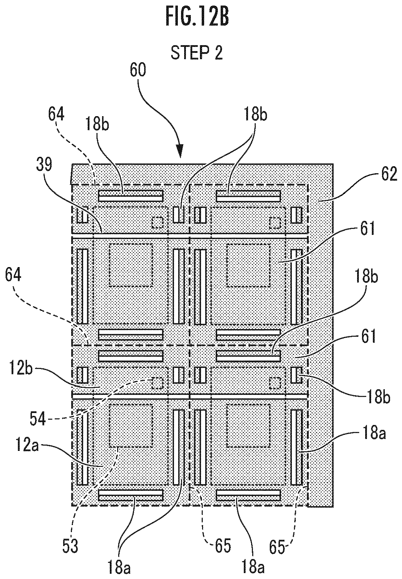

In STEP 2 of FIG. 12B, the standing parts 18a and 18b are formed on the leads 12a and 12b, respectively. The formation of the standing parts 18a and 18b has been outlined with reference to FIG. 7 and the like, but the details are as follows.

In the lead frame 60 formed in STEP 1, the rectangular region surrounded by the cuts 35 of the three sides in each unitary section 61 of the lead frame 60 is pressed from the lower surface side to the upper surface side of the lead frame 60, as illustrated mainly in FIG. 7 and FIG. 10B. Then, the rectangular region is bent upward by using the long side (bend side) without the cut 35 as the rotation axis thereby to form the standing part 18a or 18b. Thus, the rectangular region is rotated, and the through hole 36 is formed in the spot left after the standing part is created.

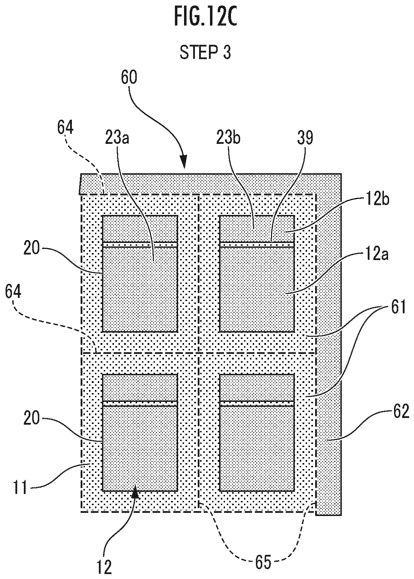

In STEP 3 of FIG. 12C, the frame 11 made of resin is formed on the lead frame 60. The lead frame 60 provided with the standing parts 18a and 18b erected in STEP 2 is set in a mold (not illustrated), and then a resin to be formed into the frame 11 is injected into the mold. After that, the resin is heat-cured to form an assembly of the substrates 15 in which the frame 11 made of the resin has been integrated to the lead frame 60. The opening 20 that opens upward is formed in the center of each unitary section 61. In each unitary section 61, the upper surfaces 23a and 23b of the leads 12a and 12b are exposed to the opening 20.

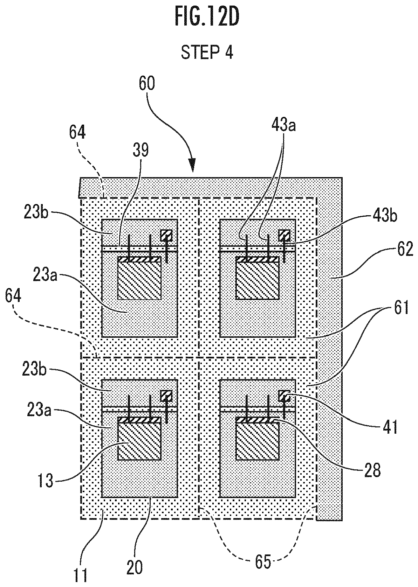

In STEP 4 of FIG. 12D, the LED 28 and the protection element 41 are joined to the upper surfaces 23a and 23b, respectively, of the leads 12a and 12b. Further, the phosphor plate 14 is bonded onto the LED 28. After that, the LED 28 and the upper surface 23b of the lead 12b are connected by bonding wires 43a, and the protection element 41 and the upper surface 23a of the lead 12a are connected by the bonding wire 43b.

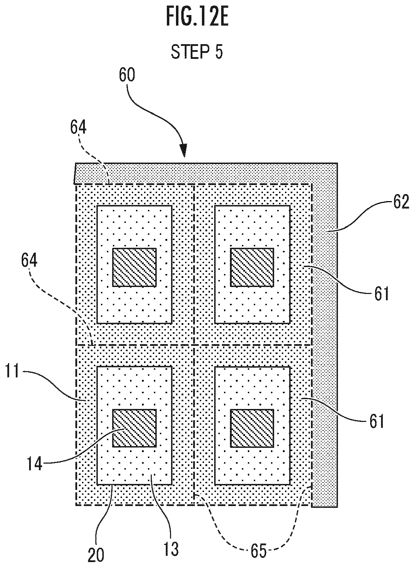

In STEP 5 of FIG. 12E, the opening 20 is covered by the reflective covering member 13. This completes the plurality of the light emitting devices 10 integrally connected in the lattice array in the common lead frame 60.

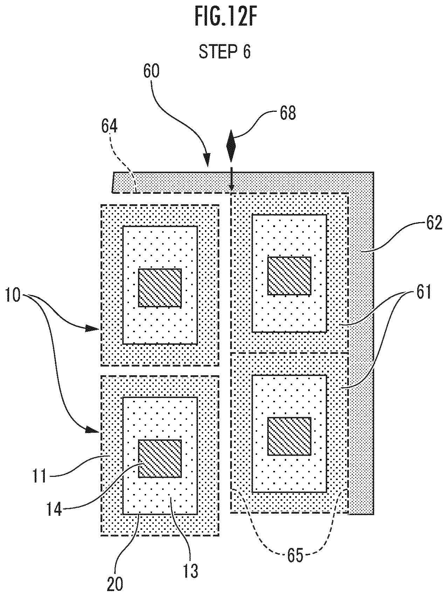

In STEP 6 of FIG. 12F, the plurality of the light emitting devices 10 in the lattice array obtained in STEP 5 are diced using a dicing blade 68 along the lateral dicing lines 64 and the longitudinal dicing lines 65. Thus, the individual light emitting devices 10 are completed.

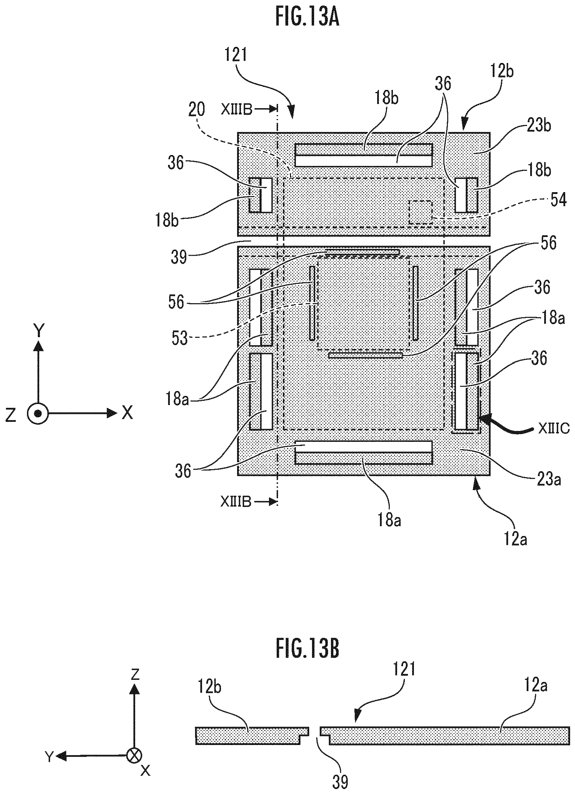

FIG. 13A is a top view of a lead frame 121 of a second embodiment of the present invention, and FIG. 13B is a sectional view along line XIIIB-XIIIB of FIG. 13A. Referring to FIG. 13A, the same elements as those in FIG. 2 are denoted by the same reference numerals, and the descriptions thereof are omitted.

As illustrated in FIG. 13A, on a lead 12a, alignment grooves 56 are formed around a die pad 53 on which an LED 28 is placed. The total of four alignment grooves 56 are formed on the outer side of the die pad 53 along the individual sides of the die pad 53 having a rectangular shape in the illustrated example. The alignment grooves 56 are formed by, for example, half-etching the upper surface of the lead 12a.

The LED 28 is placed on the cream solder applied to the die pad 53, and thereafter, the solder is thermally melted and then cooled and solidified thereby to join the LED 28 to the die pad 53 through the solder, which is a bonding layer 30.

The solder spreads on the die pad 53 in the thermally melted state. Due to the presence of the alignment grooves 56, the thermally melted solder stops at the alignment grooves 56 and remains within the region on the inner side of the alignment grooves 56. Thus, the LED 28 is aligned and joined onto the die pad 53 through the bonding layer 30 (self alignment).

In the lead frame 121, the lead 12a has standing parts 18a, two each, along each long side of the lead frame 121. One standing part 18a of the two standing parts 18a is positioned on the peripheral edge side of the lead 12a with respect to a through hole 36, and the other standing part 18a is positioned adjacently to an opening 20 with respect to the through hole 36. This structure can be provided also on the short sides of the lead 12a. Further, the structure can be provided also on the lead 12b. Thus, providing the standing parts 18a on the peripheral edge side of the lead 12a and adjacently to the opening 20 makes it possible to improve the unity with the frame 11 (mechanical strength).

According to the lead frame 121 of the second example, a slit 39 has a step, the cross section of which has an upper narrow portion and a lower wide portion, as illustrated in FIG. 13B. As described with reference to FIG. 3, the resin of the frame 11 enters also in the slit 39 and solidifies (the frame 11 being not illustrated in FIG. 13B).

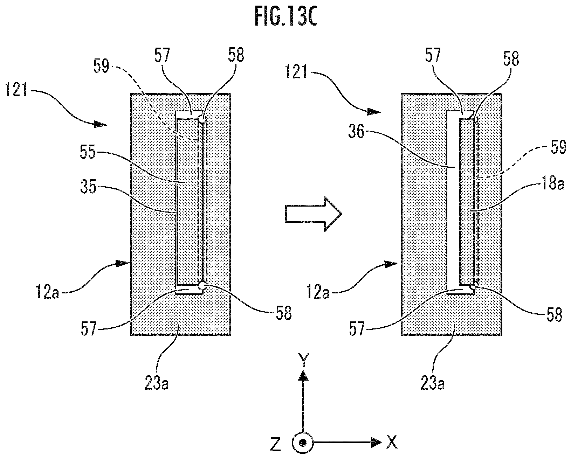

FIG. 13C is an enlarged view of modified example 3 of the standing parts 18a provided on the lead frame 121 of the second embodiment. Standing parts 18a of modified example 3 are formed in, for example, the range of XIIIC of FIG. 13A. FIG. 13C schematically illustrates an upper surface 23a of a lead 12a before and after the standing parts 18a are formed (the left and the right).

Referring to FIG. 13C, a cut 35 is formed along one of two long sides of a rectangular region 55, and a bending guide groove 59 is formed along the other long side. However, the bending guide groove 59 is formed in a lower surface 24a (the rear side of FIG. 13C) rather than the upper surface 23a of the lead 12a.

Adj acently to each short side of the rectangular region 55, athrough hole 57, which is sufficiently wider than the cut 35, is formed along the short side. Both ends of the cut 35 are connected to the through holes 57 before the standing parts 18a are formed. Both ends of the bending guide groove 59 are connected to the through holes 57 before the standing parts 18a are formed. Further, round reliefs 58 are formed at the points of connection between the through holes 57 and the bending guide groove 59. The through holes 57 may be formed as mere cuts like the cut 35.

The reliefs 58 penetrate the lead 12a at both ends of the bending guide groove 59. The reliefs 58 are formed in the lead 12a as the round through holes, and as a result, curved recessed surfaces having arc surfaces are formed in the reliefs 58 at both ends of the bending guide groove 59.

According to modified example 3, the rectangular region 55 is rotated with the bending guide groove 59 as the rotation axis against the pressing force applied from the lower surface 24a side of the lead 12a to the upper surface 23a side. As with the bending guide groove 48a in FIG. 10B, the bending guide groove 59 is formed such that the standing part 18a is formed by being accurately bent along the straight line of the bending guide groove 59. The reliefs 58 prevent the occurrence of damage such as cracks that are likely to take place at both ends of the bending guide groove 59 at the time of bending. In addition, the reliefs 58 can prevent the occurrence of distortion of the lead 12a that may take place at both ends of the bending guide groove 59. Such reliefs 58 can be formed in the manufacturing process of STEP 1.

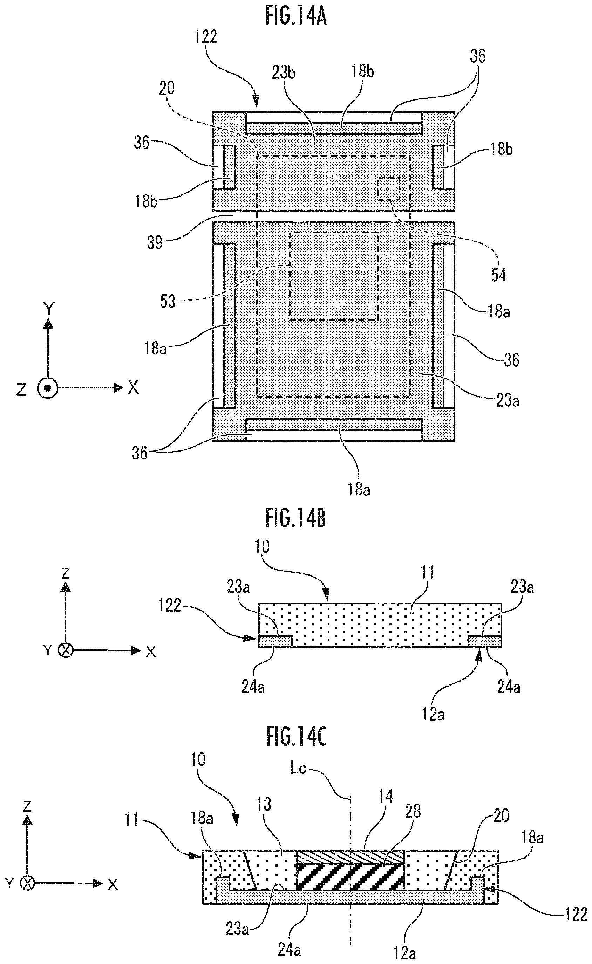

FIG. 14A is a top view of a lead frame 122 of an example not forming part of the present invention, FIG. 14B is a side view of a light emitting device 10 provided with the lead frame 122 of FIG. 14A observed in a longitudinal direction from a lead 12a side, and FIG. 14C is a sectional view of the light emitting device 10 provided with the lead frame 122 of FIG. 14A cut by a plane parallel to a slit 39 and across an LED 28.

In the lead frame 122 of this example, all standing parts 18a and 18b are formed on the opposite side from the peripheral edge side of the lead frame 122 with respect to through holes 36.

According to the lead frame 122 of this example, the standing parts 18a and 18b are formed on the opposite side from the peripheral edge side of the lead frame 122 with respect to the through holes 36. As a result, the resin of a frame 11 is disposed on the outer surface of the light emitting device 10, thus decreasing the exposed surfaces of the lead 12a and a lead 12b. In other words, at the time of singulation of the light emitting device 10 in STEP 6 of the manufacturing process, the cut surfaces of the leads 12a and 12b can be decreased, so that the processing time for the singulation can be shortened.

The above has described the present invention with reference to the first and second embodiment and the modified examples thereof; however, the shapes, the dimensions, the materials, and the like can be freely set within the scope of the present invention as defined by the appended claims. For example, the first and second embodiment and the modified examples thereof can be mixed, as appropriate, and set according to the structure and the like of a light emitting device.

Further, the light emitting elements are not limited to LEDs, but may be other light emitting elements such as, for example, vertical cavity surface emitting lasers or photonic crystal surface emitting lasers.

Further, the cases where the light emitting device 10 has two leads 12a and 12b have been described; however, the number of leads of the light emitting device may be three or more. For example, if a light emitting device has a plurality of light emitting elements, the number of leads may be three or more.

Further, although each of the presented examples has one opening 20, the light emitting device may have a plurality of openings 20. For example, the light emitting device may include two openings, and the openings may have LEDs of the same color or different colors. In such a case, the standing parts can be provided on a partition wall (frame) that partitions the two openings in addition to the frame surrounding the outer periphery.

According to the present invention, the standing parts are erected on the upper surface of the lead frame and embedded in the frame made of a resin, so that the area of contact between the resin frame and the metal lead frame increases by the area equivalent to both surfaces of the standing parts. This enhances the adhesion between the frame and the lead frame. Consequently, the mechanical strength of the light emitting device including the lead frame and the frame of the present invention is increased, thus making it possible to prevent the occurrence of failures such as disconnection.

## Claims

1. A semiconductor light emitting device (10) comprising:
a lead frame (12) having a plurality of leads (12a, 12b), at least one lead having a first main surface (23a, 23b), a second main surface (24a, 24b) opposite to the first main surface (23a, 23b), at least one standing part (18a, 18b) erected on the first main surface (23a, 23b), and at least one through hole (36) penetrating the at least one lead (12a, 12b) from the first main surface (23a, 23b) to the second main surface (24a, 24b) and extending along, and adjacent to, the at least one standing part (18a, 18b);
a resin frame (11) having an opening (20) to which the plurality of leads (12a, 12b) are exposed, and being provided in such a manner as to embed the at least one standing part (18a, 18b) therein, fill the at least one through hole (36),
and surround the opening (20); and
a light emitting element (28) mounted on the first main surface (23a) in the opening (20) and connected to the plurality of leads (12a, 12b).

2. The semiconductor light emitting device according to claim 1, wherein the at least one standing part (18a, 18b) extends along an edge portion of the lead frame (12).

3. The semiconductor light emitting device according to claim 2, wherein the at least one standing part (18a, 18b) extends along an edge portion of each lead (12a, 12b) of the plurality of leads (12a, 12b).

4. The semiconductor light emitting device according to claim 2 or 3,
wherein the lead frame (12) is made of a rectangular plate-like metal,
wherein the plurality of leads (12a, 12b) are separated from each other by a slit (39) formed in parallel to one side of the rectangle, and
wherein the at least one standing part (18a, 18b) is formed along a direction orthogonal to the slit (39) in the at least one lead (12a, 12b).

5. The semiconductor light emitting device according to claim 2 or 3,
wherein the lead frame (12) is made of a rectangular plate-like metal,
wherein the plurality of leads (12a, 12b) are separated from each other by a slit (39) formed in parallel to one side of the rectangle, and
wherein the at least one standing part (18a, 18b) is formed in parallel to the slit (39) in the at least one lead (12a 12b).

6. The semiconductor light emitting device according to any one of claims 1 to 5, wherein the at least one standing part (18a, 18b) is formed by bending a part of the at least one lead (12a, 12b).

7. The semiconductor light emitting device according to claim 6, wherein the at least one standing part (18a, 18b) is formed by bending along a bending guide groove (48a, 48b, 59) that decreases the thickness of the at least one lead (12a, 12b).

8. The semiconductor light emitting device according to claim 7, wherein curved concave surfaces are formed as reliefs (58) in corners at both ends of the bending guide groove (59).

9. The semiconductor light emitting device according to any one of claims 6 to 8, wherein the at least one standing part (18a, 18b) is orthogonally erected from the first main surface (23a, 23b) of the at least one lead (12a, 12b).

## Patentansprüche

1. Eine Halbleiter-Lichtemissionsvorrichtung (10), aufweisend:
einen Anschlussrahmen (12) mit einer Vielzahl von Anschlüssen (12a, 12b), wobei wenigstens ein Anschluss eine erste Hauptfläche (23a, 23b), eine zweite Hauptfläche (24a, 24b) gegenüber der ersten Hauptfläche (23a, 23b), wenigstens einen Erhebungsteil (18a, 18b), der sich an der ersten Hauptfläche (23a, 23b) erhebt, und wenigstens ein Durchgangsloch (36), das sich durch den wenigstens einen Anschluss (12a, 12b) von der ersten Hauptfläche (23a, 23b) zu der zweiten Hauptfläche (24a, 24b) und entlang und benachbart zu dem wenigstens einen Erhebungsteil (18a, 18b) erstreckt, aufweist,
einen Harzrahmen (11), der eine Öffnung (20), zu der die Vielzahl von Anschlüssen (12a, 12b) freiliegen, aufweist und derart vorgesehen ist, dass er den wenigstens einen Erhebungsteil (18a, 18b) einbettet, das wenigstens eine Durchgangsloch (36) füllt und die Öffnung (20) umgibt, und
ein Lichtemissionselement (28), das an der ersten Hauptfläche (23a) in der Öffnung (20) montiert ist und mit der Vielzahl von Anschlüssen (12a, 12b) verbunden ist.

2. Halbleiter-Lichtemissionsvorrichtung nach Anspruch 1, wobei sich der wenigstens eine Erhebungsteil (18a, 18b) entlang eines Randteils des Anschlussrahmens (12) erstreckt.

3. Halbleiter-Lichtemissionsvorrichtung nach Anspruch 2, wobei sich der wenigstens eine Erhebungsteil (18a, 18b) entlang eines Randteils jedes Anschlusses (12a, 12b) der Vielzahl von Anschlüssen (12a, 12b) erstreckt.

4. Halbleiter-Lichtemissionsvorrichtung nach Anspruch 2 oder 3,
wobei der Anschlussrahmen (12) aus einem rechteckigen, plattenartigen Metall ausgebildet ist,
wobei die Vielzahl von Anschlüssen (12a, 12b) voneinander durch einen Schlitz (39), der parallel zu einer Seite des Rechtecks ausgebildet ist, getrennt werden, und
wobei der wenigstens eine Erhebungsteil (18a, 18b) entlang einer Richtung orthogonal zu dem Schlitz (39) in dem wenigstens einen Anschluss (12a, 12b) ausgebildet ist.

5. Halbleiter-Lichtemissionsvorrichtung nach Anspruch 2 oder 3,
wobei der Anschlussrahmen (12) aus einem rechteckigen, plattenartigen Metall ausgebildet ist,
wobei die Vielzahl von Anschlüssen (12a, 12b) voneinander durch einen Schlitz (39), der parallel zu einer Seite des Rechtecks ausgebildet ist, getrennt werden, und
wobei der wenigstens eine Erhebungsteil (18a, 18b) parallel zu dem Schlitz (39) in dem wenigstens einen Anschluss (12a, 12b) ausgebildet ist.

6. Halbleiter-Lichtemissionsvorrichtung nach einem der Ansprüche 1 bis 5, wobei der wenigstens eine Erhebungsteil (18a, 18b) durch das Biegen eines Teils des wenigstens einen Anschlusses (12a, 12b) ausgebildet wird.

7. Halbleiter-Lichtemissionsvorrichtung nach Anspruch 6, wobei der wenigstens eine Erhebungsteil (18a, 18b) durch das Biegen entlang einer Biegungsführungsnut (48a, 48b, 59), die die Dicke des wenigstens einen Anschlusses (12a, 12b) vermindert, ausgebildet wird.

8. Halbleiter-Lichtemissionsvorrichtung nach Anspruch 7, wobei gekrümmte konkave Flächen als Reliefs (58) in Ecken an beiden Enden der Biegungsführungsnut (59) ausgebildet sind.

9. Halbleiter-Lichtemissionsvorrichtung nach einem der Ansprüche 6 bis 8, wobei sich der wenigstens eine Erhebungsteil (18a, 18b) orthogonal von der ersten Hauptfläche (23a, 23b) des wenigstens einen Anschlusses (12a, 12b) erhebt.

## Revendications

1. Dispositif électroluminescent semiconducteur (10) comprenant :
une grille de connexion (12) ayant une pluralité de conducteurs (12a, 12b), au moins un conducteur ayant une première surface principale (23a, 23b), une deuxième surface principale (24a, 24b) en vis-à-vis de la première surface principale (23a, 23b), au moins une partie de support (18a, 18b) érigée sur la première surface principale (23a, 23b), et au moins un orifice traversant (36) pénétrant dans l'au moins un conducteur (12a, 12b) depuis la première surface principale (23a, 23b) à la deuxième surface principale (24a, 24b) et s'étendant le long et à proximité de l'au moins une partie de support (18a, 18b) ;
un cadre en résine (11) ayant une ouverture (20) au niveau de laquelle la pluralité de conducteurs (12a, 12b) sont exposés, et étant prévu de sorte à y intégrer l'au moins une partie de support (18a, 18b), remplir l'au moins un orifice traversant (36) et à entourer l'ouverture (20) ; et
un élément électroluminescent (28) placé sur la première surface principale (23a) dans l'ouverture (20) et connecté à la pluralité de conducteurs (12a, 12b).

2. Dispositif électroluminescent semiconducteur selon la revendication 1, dans lequel l'au moins une partie de support (18a, 18b) s'étend le long d'une portion de bord de la grille de connexion (12).

3. Dispositif électroluminescent semiconducteur selon la revendication 2, dans lequel l'au moins une partie de support (18a, 18b) s'étend le long d'une partie de bord de chaque conducteur de la pluralité de conducteurs (12a, 12b).

4. Dispositif électroluminescent semiconducteur selon la revendication 2 ou 3,
dans lequel la grille de connexion (12) est constituée d'un métal en forme de plaque rectangulaire,
dans lequel la pluralité de conducteurs (12a, 12b) sont séparés les uns des autres par une fente (39) formée parallèlement à un côté du rectangle, et
dans lequel l'au moins une partie de support (18a, 18b) est formée le long d'une direction orthogonale à la fente (39) dans l'au moins un conducteur (12a, 12b).

5. Dispositif électroluminescent semiconducteur selon la revendication 2 ou 3,
dans lequel la grille de connexion (12) est constituée d'un métal en forme de plaque rectangulaire,
dans lequel la pluralité de conducteurs (12a, 12b) sont séparés les uns des autres par une fente (39) formée parallèlement à un côté du rectangle, et
dans lequel l'au moins une partie de support (18a, 18b) est formée parallèlement à la fente (39) dans l'au moins un conducteur (12a, 12b).

6. Dispositif électroluminescent semiconducteur selon l'une quelconque des revendications 1 à 5, dans lequel l'au moins une partie de support (18a, 18b) est formée par courbure d'une partie de l'au moins un conducteur (12a, 12b).

7. Dispositif électroluminescent semiconducteur selon la revendication 6, dans lequel l'au moins une partie de support (18a, 18b) est formée par courbure le long d'une rainure de guidage de courbure (48a, 48b, 59) qui diminue l'épaisseur de l'au moins un conducteur (12a, 12b).

8. Dispositif électroluminescent semiconducteur selon la revendication 7, dans lequel des surfaces concaves incurvées sont formées sous forme de reliefs (58) dans les coins aux deux extrémités de la rainure de guidage de courbure (59).

9. Dispositif électroluminescent semiconducteur selon l'une quelconque des revendications 6 à 8, dans lequel l'au moins une partie de support (18a, 18b) est dressée orthogonalement à partir de la première surface principale (23a, 23b) de l'au moins un conducteur (12a, 12b).
